# EUROPEAN PATENT APPLICATION

(11) **EP 3 477 711 A1**
(43) Date of publication of application: **01.05.2019**
(21) Application number: 18180983.1
(22) Date of filing: 29.06.2018
(51) Int. Cl.: H01L 31/18, B32B 37/10

(54) **COOLING DEVICE OF PHOTOVOLTAIC ASSEMBLY**

(30) Priority: 27.10.2017 CN 201721439621 U
(71) Applicant: Miasolé Equipment Integration (Fujian) Co., Ltd., 362000 Quanzhou Fujian (CN)
(72) Inventor: LE, Chuanqin, QUANZHOU, Fujian 362000 (CN); LIU, Libing, QUANZHOU, Fujian 362000 (CN); MA, Shengtao, QUANZHOU, Fujian 362000 (CN); HU, Binhua, QUANZHOU, Fujian 362000 (CN); WU, Jianqing, QUANZHOU, Fujian 362000 (CN); JIANG, Hu, QUANZHOU, Fujian 362000 (CN); LI, Tao, QUANZHOU, Fujian 362000 (CN); HU, Pengchen, QUANZHOU, Fujian 362000 (CN)
(74) Representative: Cabinet Beau de Loménie

(57) **Abstract**

Disclosed is a photovoltaic assembly, including a cooling platform (5) for supporting the photovoltaic assembly (4) to be cooled; a first high-temperature cloth unit (21) provided on the cooling platform (5); a vacuum cover (3) for forming a vacuum chamber together with the cooling platform (5), the vacuum chamber accommodating the photovoltaic assembly (4) to be cooled; a second high-temperature cloth unit (22) provided at a side of the vacuum cover (3) facing the cooling platform (5); and a lifting bracket (1) for driving the vacuum cover (3) to lift or fall. In the above-mentioned photovoltaic assembly, the vacuum cover (3) is driven and lifted by the lifting bracket (1), and forms a vacuum chamber together with the cooling platform (5). The vacuum chamber creates a pressure cooling effect for the photovoltaic assembly (4) to be cooled. In turn, the appearance defects may be reduced when the photovoltaic assembly (4) is cooled to the normal temperature.

## Description

### TECHNICAL FIELD

The present application relates generally to the field of processing photovoltaic batteries, and particularly, to a cooling device of a photovoltaic assembly.

### BACKGROUND

In comparison to the conventional rigid solar cell assemblies, the flexible solar cell assemblies are lighter, thinner, bendable, and are widely applied.

Usually, flexible solar cell assemblies need to be cooled after lamination, and then a next process can be performed. For the current flexible solar cell assemblies, the cooling method for the assemblies after lamination is commonly realized by air cooling or natural cooling.

The existing cooling method for the flexible assemblies has the following defects:
During the cooling process in the prior art, due to the strong thermal expansion and contraction effect of the flexible solar cell module, there are usually appearance defects, such as, wrinkling, bending, or waving on the surface of the assembly, which may affect the appearance and performance. Further, the long cooling time affects the producing efficiency.

### SUMMARY

The purpose of the present application is to provide a cooling device of a photovoltaic assembly, which can overcome the problems in prior art, reduce wrinkling and bending phenomenon on the surface of the photovoltaic assembly, and cool the photovoltaic assembly in a short time.

In one aspect, the present application provides a cooling device of a photovoltaic assembly, comprising:
a cooling platform adapted to support a photovoltaic assembly to be cooled;
a first high-temperature cloth unit provided on the cooling platform;
a vacuum cover for forming a vacuum chamber together with the cooling platform, the vacuum chamber being adapted to accommodate the photovoltaic assembly to be cooled;
a second high-temperature cloth unit provided at a side of the vacuum cover facing the cooling platform; and
a lifting bracket for driving the vacuum cover to lift or fall.

In another aspect, the first high-temperature cloth unit comprises a first high-temperature cloth layer being fixed on the cooling platform; and/or
the second high-temperature cloth unit comprises a second high-temperature cloth layer being fixed on an inner surface of the vacuum cover.

In another aspect, the first high-temperature cloth unit comprises a first high-temperature cloth transporting belt; and/or
the second high-temperature cloth unit comprises a second high-temperature cloth transporting belt.

In another aspect, the first high-temperature cloth transporting belt comprises a first transporting belt and a third high-temperature cloth layer provided on the first transporting belt; and/or
the second high-temperature cloth transporting belt comprises a second transporting belt and a fourth high-temperature cloth layer provided on the second transporting belt.

In another aspect, a cooling chamber is provided inside the cooling platform, and includes a liquid inlet and a liquid outlet on either end of the cooling chamber.

In another aspect, the lifting bracket comprises a supporting frame and a lifting drive unit, wherein the vacuum cover is provided on the supporting frame, and the supporting frame is fixed on the cooling platform through the lifting drive unit.

In another aspect, the supporting frame comprises a rim, and a plurality of transverse beams and a plurality of longitudinal beams provided in the rim, wherein the transverse beams and the longitudinal beams are perpendicularly intersected.

In another aspect, the lifting drive unit comprises four cylinders, a telescopic rod of each of the four cylinders is connected to the supporting frame, and a cylinder body of each of the four cylinders is fixed to the cooling platform.

In another aspect, the vacuum cover comprises a vacuum plastic film.

In another aspect, the vacuum cover further comprises a silicon sealing strip. The silicon sealing strip is positioned between the vacuum plastic film and the cooling platform, when the vacuum plastic film and the cooling platform form a vacuum chamber.

In another aspect, the first high-temperature cloth unit comprises: a first high-temperature cloth layer laid on the cooling platform; the second high-temperature cloth unit comprises a second high-temperature cloth layer laid on an inner surface of the vacuum cover.

In another aspect, the first high-temperature cloth unit comprises: a first high-temperature cloth layer fixed on the cooling platform; or the second high-temperature cloth unit comprises a second high-temperature cloth layer fixed on an inner surface of the vacuum cover.

In another aspect, the first high-temperature cloth unit comprises a first high-temperature cloth transporting belt; or the second high-temperature cloth unit comprises a second high-temperature cloth transporting belt.

In another aspect, the first high-temperature cloth transporting belt comprises a first transporting belt and a third high-temperature cloth layer provided on the first transporting belt; or the second high-temperature cloth transporting belt comprises a second transporting belt and a fourth high-temperature cloth layer provided on the second transporting belt.

In another aspect, the supporting frame comprises a rim, and a plurality of transverse beams and a plurality of longitudinal beams provided in the rim, wherein the transverse beams and the longitudinal beams are intersected at an angle.

In another aspect, the cooling platform is divided into a plurality of rectangular regions along the transmitting direction of the photovoltaic assembly to be cooled; and each of the rectangular regions of the cooling platform 5 is supported by a plurality of supports.

In another aspect, each of the plurality of rectangular regions of the cooling platform has a plurality of vacuum conduit ports; and the cooling platform further has a main vacuum conduit port which has a diameter larger than that of each of the plurality of vacuum conduit ports of the rectangular regions of the cooling platform.

In another aspect, the supporting frame is divided into a plurality of rectangular regions along the transmitting direction of the photovoltaic assembly to be cooled; and the number of the rectangular regions of the supporting frame equal to the number of the rectangular regions of the cooling platform.

In another aspect, each of the rectangular regions of the supporting frame has a shape and a position corresponding to that of the respective rectangular regions of the cooling platform.

In another aspect, the vacuum plastic film of the vacuum cover is a flexible film; when an external vacuum suction device creates a vacuum between the vacuum cover and the cooling platform, and a vacuum chamber is formed between the vacuum cover and the cooling platform, the vacuum plastic film covers the photovoltaic module to be cooled and applies pressure on the photovoltaic module to be cooled.

According to the cooling device of the photovoltaic assembly in the present application, the vacuum cover is driven to lift or fall by the lifting bracket, and forms a vacuum chamber together with the cooling platform. The pressure outside of the vacuum chamber is an atmospheric pressure, and a pressure difference is formed between inside and outside of the vacuum chamber, such that a pressure cooling effect is formed on the photovoltaic assembly to be cooled in the vacuum chamber. In turn, the appearance defects such as wrinkling, bending and waving, which would affect the appearance and performance of the product, may be reduced, when the photovoltaic assembly to be cooled is cooled to the normal temperature. Further, the first high-temperature cloth unit and the second high-temperature cloth unit clamp the photovoltaic assembly to be cooled from upper and lower sides, such that the photovoltaic assembly to be cooled is protected during the pressure cooling, and the flatness of the photovoltaic assembly to be cooled can be improved. Further, a cooling chamber is provided inside the cooling platform, and a liquid inlet and a liquid outlet are provided on either end of the cooling chamber, so as to ensure the circulation of the coolant in the cooling chamber, allowing the photovoltaic assembly to be cooled rapidly and thereby greatly improving the producing and processing efficiency.

### BRIEF DESCRIPTION OF THE DRAWINGS

Fig. 1 is a schematic structural view of a cooling device of a photovoltaic assembly according to an embodiment of the present application;
Fig. 2 is a schematic structural view of a supporting frame provided by another embodiment of the present application; and
Fig. 3 is a schematic structural view of a cooling platform provided by another embodiment of the present application.

### Reference numbers are listed:

1 - Lifting bracket
11- Supporting frame
12- Lifting drive unit
13- Rim
14- Transverse beam
15- Longitudinal beam
21- First high-temperature cloth unit
22- Second high-temperature cloth unit
3 - Vacuum cover
4 - Photovoltaic assembly to be cooled
5 - Cooling platform
51- Cooling chamber
52- Liquid inlet
53- Liquid outlet
54- Suction hole

### DETAILED DESCRIPTION

Embodiments of the present application will be described in detail below, examples of which are illustrated in the accompanying drawings, in which the same or similar reference numerals denote the same or similar elements having the same or similar functions throughout. The embodiments described below with reference to the drawings are exemplary, and are used to explain the present application, rather than be interpreted as limiting the present application.

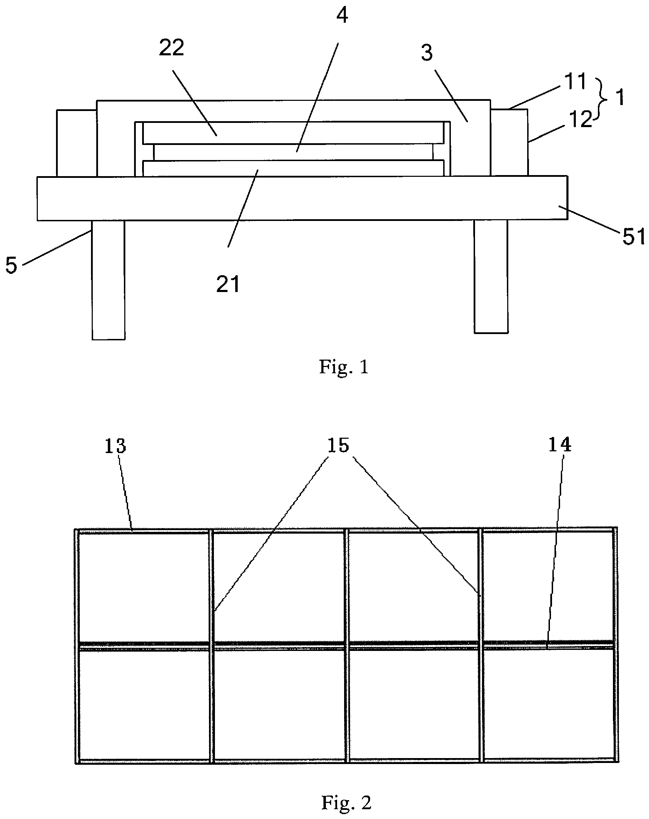

As shown in Fig. 1, an embodiment of the present application provides a cooling device of a photovoltaic assembly, including:
a cooling platform 5 for supporting a photovoltaic assembly 4 to be cooled;
a first high-temperature cloth unit 21 provided on the cooling platform 5;
a vacuum cover 3 for forming a vacuum chamber together with the cooling platform 5, the vacuum chamber accommodating the photovoltaic assembly 4 to be cooled;
a second high-temperature cloth unit 22 provided at a side of the vacuum cover 3 facing the cooling platform 5; and
a lifting bracket 1for driving the vacuum cover 3 to lift or fall.

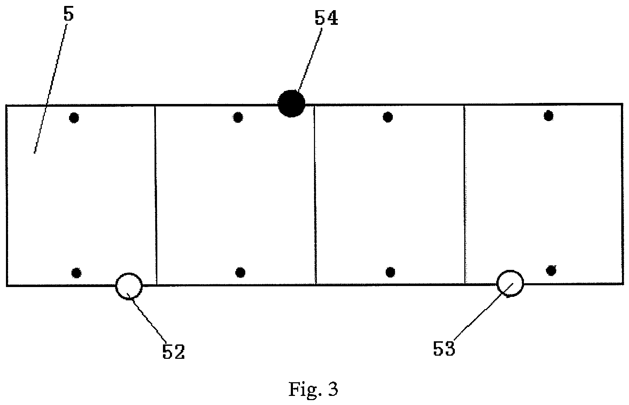

In an embodiment, as shown in Fig. 3, a cooling chamber 51 is provided inside the cooling platform 5, and a liquid inlet 52 and a liquid outlet 53 are provided on either end of the cooling chamber 51.

In the cooling device of the photovoltaic assembly provided by the present application, the vacuum cover 3 driven by the lifting bracket 1 depresses and covers on the photovoltaic assembly 4 to be cooled. In an embodiment of the present application, the vacuum cover 3 may be in press contact with the cooling platform 5. A cavity may be formed between the vacuum cover 3 and the cooling platform 5, and a vacuum chamber may be formed by directly vacuuming the cavity through an external vacuum device. Alternatively, a suction hole 54 may be provided on the cooling platform 5 under the vacuum cover 3 and communicates the cavity. The suction hole 54 communicates the external vacuum device, such that a vacuum can be created in the cavity, and finally the cavity is formed as the vacuum chamber.

The pressure outside of the vacuum chamber is an atmospheric pressure, and a pressure difference is formed between the inside and outside of the vacuum chamber, such that a pressure cooling effect is formed on the photovoltaic assembly 4 to be cooled in the vacuum chamber. In turn, the appearance defects such as wrinkling, bending, and waving, which would affect the appearance and performance of the product, may be reduced when the photovoltaic assembly 4 to be cooled is cooled to a normal temperature. Further, the first high-temperature cloth unit 21 and the second high-temperature cloth unit 22 clamp the photovoltaic assembly 4 to be cooled from upper and lower sides, such that the photovoltaic assembly 4 to be cooled is protected during the pressure cooling, and the flatness of the photovoltaic assembly 4 to be cooled can be improved. Further, a cooling chamber 51 is provided inside the cooling platform 5, and a liquid inlet 52 and a liquid outlet 53 are provided on either end of the cooling chamber 51, so as to ensure the circulation of the coolant in the cooling chamber 51. Water is generally used as the coolant, allowing the photovoltaic assembly 4 to be cooled can be cooled rapidly, and thereby greatly improving the producing and processing efficiency.

In an embodiment of the present application, the first high-temperature cloth unit 21 and the second high-temperature cloth unit 22 may be implemented in various manners. In an embodiment, the first high-temperature cloth unit 21 includes a first high-temperature cloth layer, the first high-temperature cloth layer being fixed on the cooling platform 5; and/or the second high-temperature cloth unit 22 includes a second high-temperature cloth layer fixed on an inner surface of the vacuum cover 3. That is, in one of the manners, the first high-temperature cloth unit 21 is a high-temperature cloth layer which is unmovable in left and right directions, and the second high-temperature cloth unit 22 adopts another structure. In another manner, the first high-temperature cloth unit 21 adopts another structure, and the second high-temperature cloth unit 22 is a high-temperature cloth layer which is unmovable in left and right directions. In an embodiment, each of the first high-temperature cloth unit 21 and the second high-temperature cloth unit 22 is a high-temperature cloth layer which are unmovable in left and right directions, and the second high-temperature cloth unit 22 only moves up-down along with the vacuum cover 3, and both of the first high-temperature cloth unit 21 and the second high-temperature cloth unit 22 only serve for upper and lower clamping as well as protecting the photovoltaic assembly 4 to be cooled.

Alternatively, in an embodiment, the first high-temperature cloth unit 21 includes a first high-temperature cloth transporting belt, and/or the second high-temperature cloth unit 22 includes a second high-temperature cloth transporting belt. In an embodiment, the first high-temperature cloth transporting belt includes a first transporting belt and a third high-temperature cloth layer provided on the first transporting belt; and/or the second high-temperature cloth transporting belt includes a second transporting belt and a fourth high-temperature cloth layer provided on the second transporting belt. That is, the first high-temperature cloth unit 21 and the second high-temperature cloth unit 22 are movable in left and right directions, serving for the delivery of the photovoltaic assembly 4 to be cooled, in addition to the upper and lower clamping as well as protecting the photovoltaic assembly 4 to be cooled. And, in order to avoid the wear of the high-temperature cloth after a long period of use, the first high-temperature cloth transporting belt and the second high-temperature cloth transporting belt are disposed such that the contact area with the photovoltaic assembly 4 to be cooled can be easily replaced.

The above-mentioned second transporting belt may be installed in the vacuum cover or on the lifting bracket through a structure such as an installing bracket.

It should be noted that the first transporting belt and the third high-temperature cloth layer may be an integral structure, and the second transporting belt and the fourth high-temperature cloth layer may be an integral structure. The above-mentioned first high-temperature cloth unit may be sized as required, and the length thereof may be greater than the length of the cooling platform, such that the photovoltaic assembly to be cooled can be delivered to the cooling platform. The above-mentioned vacuum cover may be selected to cover or not to cover the first high-temperature cloth unit, according to the actual needs.

As shown in Fig. 1, in an embodiment, the lifting bracket 1 is provided on the cooling platform 5, or on the ground, or hung and lifted.

Wherein, generally the lifting bracket 1 is provided on the cooling platform 5. However, the lifting bracket 1 is not limited to provide on the cooling platform 5, instead, it may be provided on the ground; or the lifting bracket is hung and lifted under the roof of the workshop by means of a lifting rope, a lifting frame, or the like, so long as the lifting can be achieved.

As shown in Fig. 1, in an embodiment, the lifting bracket 1 includes a supporting frame 11 and a lifting drive unit 12. The vacuum cover 3 is provided on the supporting frame 11, and the supporting frame 11 is supported and fixed on the cooling platform 5 through the lifting drive unit 12.

As shown in Fig. 2, in an embodiment, the supporting frame 11 includes a rim 13, and a plurality of transverse beams 14 and a plurality of longitudinal beam 15 provided in the rim 13. The transverse beams 14 and the longitudinal beams 15 are perpendicularly intersected. In an embodiment, the supporting frame 11 further includes a fixing member. A plurality of fixing members are provided on the periphery of the rim 13, for fixing each edge of the vacuum cover 3, respectively.

In an embodiment, the lifting drive unit 12 includes four cylinders. A telescopic rod of each of the four cylinders is connected to the supporting frame 11, and a cylinder body of each of the four cylinders is fixed to the cooling platform 5. Those skilled in the art may know that the lifting drive unit 12 can be adopted as a liquid cylinder, a spring, or the like.

In an embodiment, the vacuum cover 3 includes a vacuum plastic film. In an embodiment, the vacuum cover 3 further includes a silicon sealing strip. When the vacuum plastic film is covered and installed on the photovoltaic assembly 4 to be cooled, that is, when a vacuum chamber is formed between the vacuum plastic film and the cooling platform 5, the silicon sealing strip is positioned between the vacuum plastic film and the cooling platform 5.

When the vacuum plastic film is connected to the silicon sealing strip and is depressed on the cooling platform 5 together with the lifting bracket 1, a cavity is formed between the vacuum plastic film and the cooling platform 5, such that a vacuuming operation is available. The silicon sealing strip further ensures the sealing effect of the cavity.

In an embodiment, the cooling device of the photovoltaic assembly further includes a controller which is connected to both the lifting bracket 1 and the transport device. The controller can flexibly adjust the actions of the lifting bracket 1 and the transport device, so as to ensure smooth operation of each component of the present application.

The detailed operation of the present application will be explained as follows:
After the photovoltaic assembly 4 to be cooled is laminated, the photovoltaic assembly 4 to be cooled is carried by the high-temperature cloth transporting belt to the cooling platform 5 according to the present application. Now the photovoltaic assembly 4 to be cooled is disposed between two high-temperature cloth transporting belts. The lifting bracket 1 provided with the silicon sealing strip and the vacuum plastic film starts to depress, and forms a vacuum cavity by pressing and combining with the cooling platform 5. A vacuum pump creates a vacuum in the cavity between the cooling platform 5 and the upper-layer vacuum plastic film through a suction hole 54 on the cooling platform 5. Thus, the pressure outside the vacuum plastic film is the atmosphere pressure, and then a pressure difference is formed between inside and outside of the vacuum chamber. The pressure cooling treatment is started for the photovoltaic assembly 4 to be cooled, so as to ensure that the cooling for the photovoltaic assembly 4 to be cooled is under a vacuum environment, and that the cooling circulation water in the cooling platform 5 is always on to provide the cool capacity for cooling the photovoltaic assembly 4 to be cooled to a normal temperature. After the cooling is finished, the vacuum is broken through the suction hole 54 in the cooling platform 5, then the lifting bracket 1 is lifted, and the photovoltaic assembly 4 to be cooled is carried by the high-temperature cloth transporting belt to leave the cooling platform 5, and then the whole pressure cooling is finished.

In one of the embodiments, the first high-temperature cloth unit 21 comprises a first high-temperature cloth layer laid on the cooling platform; the second high-temperature cloth unit 22 comprises a second high-temperature cloth layer laid on an inner surface of the vacuum cover.

In one of the embodiments, the first high-temperature cloth unit 21 comprises: a first high-temperature cloth layer fixed on the cooling platform; or the second high-temperature cloth unit 22 comprises a second high-temperature cloth layer fixed on an inner surface of the vacuum cover.

In one of the embodiments, the first high-temperature cloth unit 21 comprises a first high-temperature cloth transporting belt; or the second high-temperature cloth unit 22 comprises a second high-temperature cloth transporting belt.

In one of the embodiments, the first high-temperature cloth transporting belt comprises a first transporting belt and a third high-temperature cloth layer provided on the first transporting belt; or the second high-temperature cloth transporting belt comprises a second transporting belt and a fourth high-temperature cloth layer provided on the second transporting belt.

In one of the embodiments, the supporting frame 11 comprises a rim 13, and a plurality of transverse beams 14 and a plurality of longitudinal beams 15 provided in the rim 13, wherein the transverse beams 14 and the longitudinal beams 15 are intersected at an angle.

In one of the embodiments, the cooling platform 5 is divided into a plurality of rectangular regions along the transmitting direction of the photovoltaic assembly to be cooled 4; and each of the rectangular regions of the cooling platform 5 is supported by a plurality of supports.

In one of the embodiments, each of the plurality of rectangular regions of the cooling platform 5 has a plurality of vacuum conduit ports; and the cooling platform 5 further has a main vacuum conduit port which has a diameter larger than that of each of the plurality of vacuum conduit ports of the rectangular regions of the cooling platform.

In one of the embodiments, the supporting frame 11 is divided into a plurality of rectangular regions along the transmitting direction of the photovoltaic assembly to be cooled 4; and the number of the rectangular regions of the supporting frame 11 equal to the number of the rectangular regions of the cooling platform 5.

In one of the embodiments, each of the rectangular regions of the supporting frame 11 has a shape and a position corresponding to that of the respective rectangular regions of the cooling platform 5.

In one of the embodiments, the vacuum plastic film of the vacuum cover 3 is a flexible film; when an external vacuum suction device creates a vacuum between the vacuum cover 3 and the cooling platform 5, and a vacuum chamber is formed between the vacuum cover 3 and the cooling platform 5, the vacuum plastic film covers the photovoltaic module to be cooled 4 and applies pressure on the photovoltaic module to be cooled 4.

Although the present application describes a cooling device applied to a flexible photovoltaic module, those skilled in the art would appreciate that the cooling device of the present application may be applied to other photovoltaic modules.

## Claims

1. A cooling device of a photovoltaic assembly, **characterized in that** comprising:
a cooling platform (5) adapted to support a photovoltaic assembly (4) to be cooled;
a first high-temperature cloth unit (21) provided on the cooling platform (5);
a vacuum cover (3) for forming a vacuum chamber together with the cooling platform (5), the vacuum chamber being adapted to accommodate the photovoltaic assembly (4) to be cooled;
a second high-temperature cloth unit (22) provided at a side of the vacuum cover (3) facing the cooling platform (5); and
a lifting bracket (1) for driving the vacuum cover (3) to lift or fall.

2. The cooling device of the photovoltaic assembly according to claim 1, **characterized in that** the first high-temperature cloth unit (21) comprises a first high-temperature cloth layer fixed on the cooling platform (5); and/or
the second high-temperature cloth unit (22) comprises a second high-temperature cloth layer fixed on an inner surface of the vacuum cover (3).

3. The cooling device of the photovoltaic assembly according to claim 1, **characterized in that** the first high-temperature cloth unit (21) comprises a first high-temperature cloth transporting belt; and/or
the second high-temperature cloth unit (22) comprises a second high-temperature cloth transporting belt.

4. The cooling device of the photovoltaic assembly according to claim 3, **characterized in that** the first high-temperature cloth transporting belt comprises a first transporting belt and a third high-temperature cloth layer provided on the first transporting belt; and/or
the second high-temperature cloth transporting belt comprises a second transporting belt and a fourth high-temperature cloth layer provided on the second transporting belt.

5. The cooling device of the photovoltaic assembly according to claim 1, **characterized in that** a cooling chamber (51) is provided inside the cooling platform (5), and includes a liquid inlet (52) and a liquid outlet (53) on either end of the cooling chamber (51).

6. The cooling device of the photovoltaic assembly according to claim 1, **characterized in that** the lifting bracket (1) comprises a supporting frame (11) and a lifting drive unit (12), the vacuum cover (3) is provided on the supporting frame (11), and the supporting frame (11) is fixed on the cooling platform (5) through the lifting drive unit (12).

7. The cooling device of the photovoltaic assembly according to claim 6, **characterized in that** the supporting frame (11) comprises a rim (13), and a plurality of transverse beams (14) and a plurality of longitudinal beams (15) provided in the rim (13), wherein the transverse beams (14) and the longitudinal beams (15) are perpendicularly intersected.

8. The cooling device of the photovoltaic assembly according to claim 6, **characterized in that** the lifting drive unit (12) comprises four cylinders, a telescopic rod of each of the four cylinders is connected to the supporting frame (11), and a cylinder body of each of the four cylinders is fixed to the cooling platform (5).

9. The cooling device of the photovoltaic assembly according to anyone of claims 1-8, **characterized in that** the vacuum cover (3) comprises a vacuum plastic film.

10. The cooling device of the photovoltaic assembly according to claim 9, **characterized in that** the vacuum cover (3) further comprises a silicon sealing strip, which is positioned between the vacuum plastic film and the cooling platform (5) when the vacuum plastic film and the cooling platform (5) form a vacuum chamber.

11. The cooling device of the photovoltaic assembly according to claim 1, wherein the first high-temperature cloth unit (21) comprises: a first high-temperature cloth layer laid on the cooling platform;
the second high-temperature cloth unit (22) comprises a second high-temperature cloth layer laid on an inner surface of the vacuum cover.

12. The cooling device of the photovoltaic assembly according to claim 1, wherein the first high-temperature cloth unit (21) comprises: a first high-temperature cloth layer fixed on the cooling platform; or
the second high-temperature cloth unit (22) comprises a second high-temperature cloth layer fixed on an inner surface of the vacuum cover.

13. The cooling device of the photovoltaic assembly according to claim 1, wherein the first high-temperature cloth unit (21) comprises a first high-temperature cloth transporting belt; or
the second high-temperature cloth unit (22) comprises a second high-temperature cloth transporting belt.

14. The cooling device of the photovoltaic assembly according to claim 3, wherein the first high-temperature cloth transporting belt comprises a first transporting belt and a third high-temperature cloth layer provided on the first transporting belt; or
the second high-temperature cloth transporting belt comprises a second transporting belt and a fourth high-temperature cloth layer provided on the second transporting belt.

15. The cooling device of the photovoltaic assembly according to claim 6, wherein the supporting frame (11) comprises a rim (13), and a plurality of transverse beams (14) and a plurality of longitudinal beams (15) provided in the rim (13), wherein the transverse beams (14) and the longitudinal beams (15) are intersected at an angle.
